(19) Europäisches Patentamt
European Patent Office
Office européen des brevets

(11) Publication number: 0 229 497 A1

(12) # EUROPEAN PATENT APPLICATION

(21) Application number: 86309675.6

(51) Int.Cl.³: G 01 T 1/29

(22) Date of filing: 11.12.86

(30) Priority: 11.12.85 US 807650

(43) Date of publication of application: 22.07.87 Bulletin 87/30

(84) Designated Contracting States: AT BE CH DE ES FR GB GR IT LI LU NL SE

(71) Applicant: FutureTech Industries, Inc.
P.O. Box 2218
Gainesville Florida 32601(US)

(72) Inventor: Cox, John D.
3416 S.E. 29th Boulevard
Gainesville Florida 32601(US)

(72) Inventor: Jacobs, Alan M.
2120 N.W. 20th Street
Gainesville Florida 32601(US)

(72) Inventor: Scott, Stephen A.
3619 N.W. 41st Terrace
Gainesville Florida 32601(US)

(74) Representative: Tomlinson, Kerry John et al,
Frank B. Dehn & Co. European Patent Attorneys Imperial House 15-19 Kingsway
London WC2B 6UZ(GB)

(54) X-ray imaging system and method.

(57) The x-ray imaging system comprises an x-ray source (12) for producing an x-ray beam and an x-ray detector (14). The x-ray detector comprises a solid state integrated circuit having a silicon substrate and a plurality of charge storage devices. A circuit is provided for placing a charge on the charge storage devices and the integrated circuit is disposed in an x-ray permeable material. The detector is positioned in an x-ray beam such that the charge is dissipated by free electrons produced by interaction between the x-ray beam and the silicon substrate of the integrated circuit.

FIG. 1.

10
HIGH RESOLUTION MONITOR (IMAGE DISPLAY) 20
22
LASER DISC RECORDER (ARCHIVING)
16
18
14
0
DETECTOR
12
COMPUTER MONITOR 26
IMAGE PROCESSOR
KEYBOARD
24
28
102
104
DRY SILVER PRINTER (HARDCOPY OUTPUT)
PRE-PROCESSOR (NORMALIZATION)

EP 0 229 497 A1

# X-RAY IMAGING SYSTEM AND METHOD

## Field of the Invention

This invention relates to x-ray imaging systems and particularly to an x-ray imaging system which utilizes a solid state x-ray detector.

## Discussion of Related Art

Presently, x-ray imaging systems are utilized in a variety of applications, both as medical diagnostic tools and for industrial quality control. The most common form of x-ray detection resides in the use of silver halide film. However, the use of such film requires the performance of several wet, control-requiring chemical developing steps. In addition, this film is expensive, thus increasing the cost of x-ray images produced in this manner.

It would be highly desirable, therefore, to produce an x-ray imaging system which does not require the use of silver halide film. Several detectors have been proposed for this purpose.

For example, U.S. Patent No. 4,471,378 discloses a light and particle image intensifier which includes a scintillator and photocathode unit for converting incident-image-conveying light or charged particles to photoelectrons and a charge coupled device for detecting the photoelectrons and transmitting to data processing and video equipment information relating to the quantity or energy level as well as the location of the electrons impinging on the sensing areas of the charge coupled device.

U.S. Patent No. 4,413,280 discloses an x-ray imaging apparatus which includes a transducer for converting incident x-radiation to a corresponding pattern of electrical charges. The charges generated by the transducer are accelerated onto an array of charge detecting or charge storing devices which store the charges in the form of an electrical signal corresponding to the charge pattern.

## SUMMARY OF THE INVENTION

One object of the present invention is to provide a solid state imaging system and detector which are highly sensitive to x-radiation and can produce highly accurate x-ray images.

Another object of the present invention is to provide an x-ray imaging system and detector which can be produced by conventional solid state fabrication technology.

A further object of the present invention is to provide a solid state imaging detector which can be produced in such small sizes as to enable its use in very confined areas.

Another object of the present invention is to provide an x-ray imaging detector which can be substituted directly for x-ray film used in conventional x-ray imaging systems.

Yet another object of the present invention is to provide an x-ray detector which is relatively inexpensive to fabricate so as to enable its use in fixed locations for ease of periodic x-ray analysis of mechanical structures and the like.

In accordance with the above and other objects, the present invention is an x-ray imaging system comprising an x-ray source for producing an x-ray field, and an x-ray detector. The x-ray detector comprises a solid state integrated circuit having a plurality of charge storage devices and a circuit for placing a charge on the charge storage devices. The charge storage devices are disposed in an x-ray permeable material and the detector is positioned in the x-ray field such that the charge is dissipated by secondary radiation produced by interaction of the x-ray field in the semiconductor substrate of the solid state integrated circuit.

The charge storage devices may be divided into groups to form pixels. Each pixel comprises one or a plurality of charge storage devices and the exposure times for discharging the charge storage devices in a single pixel can be different from one another to provide a gray scale.

In accordance with other aspects of the invention, the integrated circuit may be a dynamic random access memory.

In a preferred embodiment, each charge storage device comprises a single cell of the integrated circuit. The cells are spaced from each other such that dead space exists therebetween. Also, the cells are produced in banks of 32,000 with about 1/4 mm dead space between banks. A plurality of detectors may be stacked with the cells of the detectors staggered such that each cell of one detector is positioned behind the gap between cells of another detector so as to eliminate all dead space.

The imaging system also includes processing circuitry for accessing the cells of a detector. The processing circuitry may include a system for normalizing the outputs of all of the cells to compensate for various inherent differences in radiation sensitivities of the various cells.

## BRIEF DESCRIPTION OF THE DRAWINGS

The above and other objects of the present invention will become more readily apparent as the invention is more clearly understood from the following detailed description of an exemplary embodiment thereof, reference being had to the accompanying drawings in which like reference numerals represent like parts throughout, and in which:

Figure 1 is a block diagram of an x-ray imaging system according to the present invention;

Figure 2 is a circuit diagram of an integrated circuit detector used in the imaging system of Figure 1;

Figure 3 is an enlarged schematic showing one charge storage capacitor of the circuit diagram of Figure 2;

Figure 4 is a cross section of a chip showing the structure depicted schematically in Figure 3;

Figure 5 is a view of a portion of the detector of the present invention stacked over additional detectors to fill up the dead space between cells;

Figure 6 is an end elevational view of the stacked detectors of Figure 5;

Figure 7 is a diagrammatic representation showing the system of the present invention used in place of x-ray film;

Figure 8 is a flow diagram depicting a method of normalizing the cells of the present invention; and

Figure 9 shows an alternative orientation of the source and detector.

## DESCRIPTION OF THE PREFERRED EMBODIMENTS

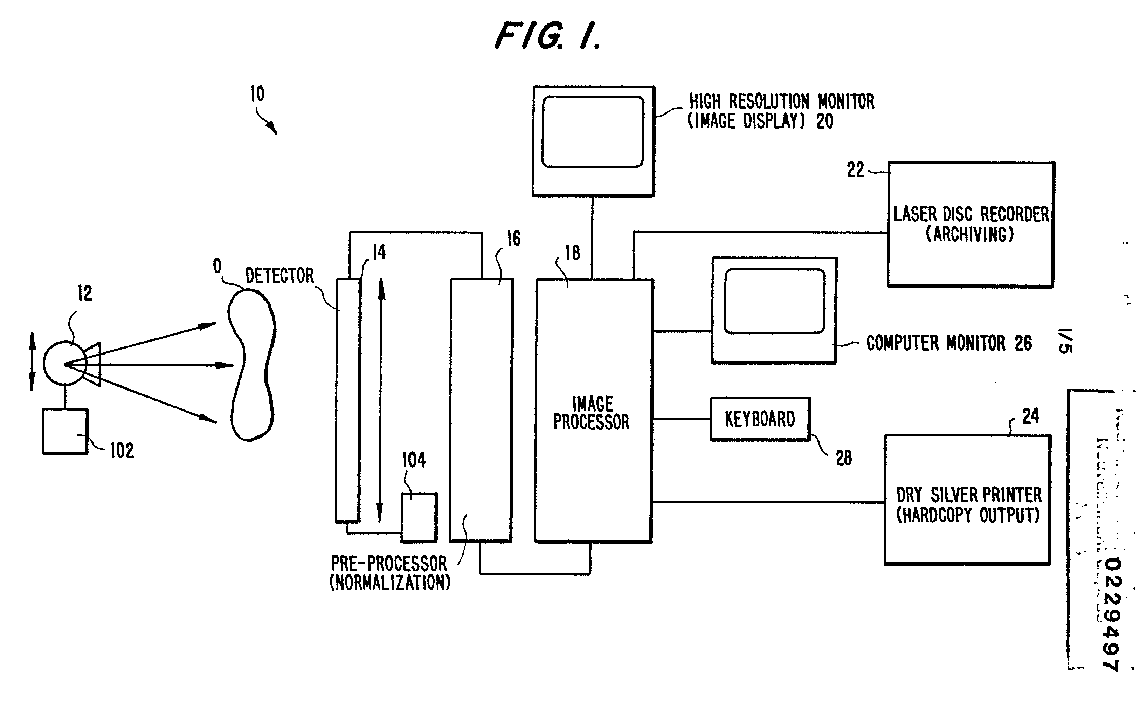

Figure 1 shows the x-ray system 10 to comprise an x-ray source 12 and a detector 14 positioned to receive the radiation from source 12. Source 12 can be any standard x-radiation source such as manufactured by G.E. or Siemens, or can be an ultra small focal spot source such as manufactured by Ridge or Magnaflux. A source with any size of focal spot can be used. Currently, the smallest focal spot available is one micron. Also, the source 12 and detector can be placed as close to the object O to be x-rayed as desired due to the configuration of the detector 14, as will become readily apparent.

Detector 14 may be a dynamic random access memory such as the IS32 OpticRAM sold by Micron Technology, Inc. of Boise, Idaho. This device is a silicon integrated circuit DRAM having 65,536 elements and is used as a solid state light sensitive detector. The Micron DRAM is specifically adapted to sense light inasmuch as there is no opaque surface covering the integrated circuit. However, any type of dynamic random access memory may be used for detector 14 as long as the covering is transparent to x-radiation. In fact, as will become apparent, any type of dynamic memory element may be used as detector 14. The memory element does not have to be a random access memory, although the use of a random access memory facilitates preprocessing and image processing routines.

The output of detector 14 is passed to preprocessor 16 which serves the function of normalizing the outputs of all of the cells of detector 14. That is, the sensitivity of the cells of detector 14 will inherently vary. A normalization value can be stored in preprocessor 16 so as to normalize the output of each of the cells to ensure a field-describing reading.

The normalized output of preprocessor 16 is passed to image processor 18 which manipulates the data using conventional image processing programs as well as new image processing programs which will be made possible by the present invention, such as "zoom" programs which are not currently in existence. This image can be displayed on a high resolution monitor 20, can be stored on a laser disc recorder 22, can be printed using a dry silver printer 24, or can be sent e.g. via satellite to remote image processors (not shown). A menu driven program is displayed on a computer monitor 26 prompting appropriate instructions and data which can be entered into the image processor 18 using a keyboard 28.

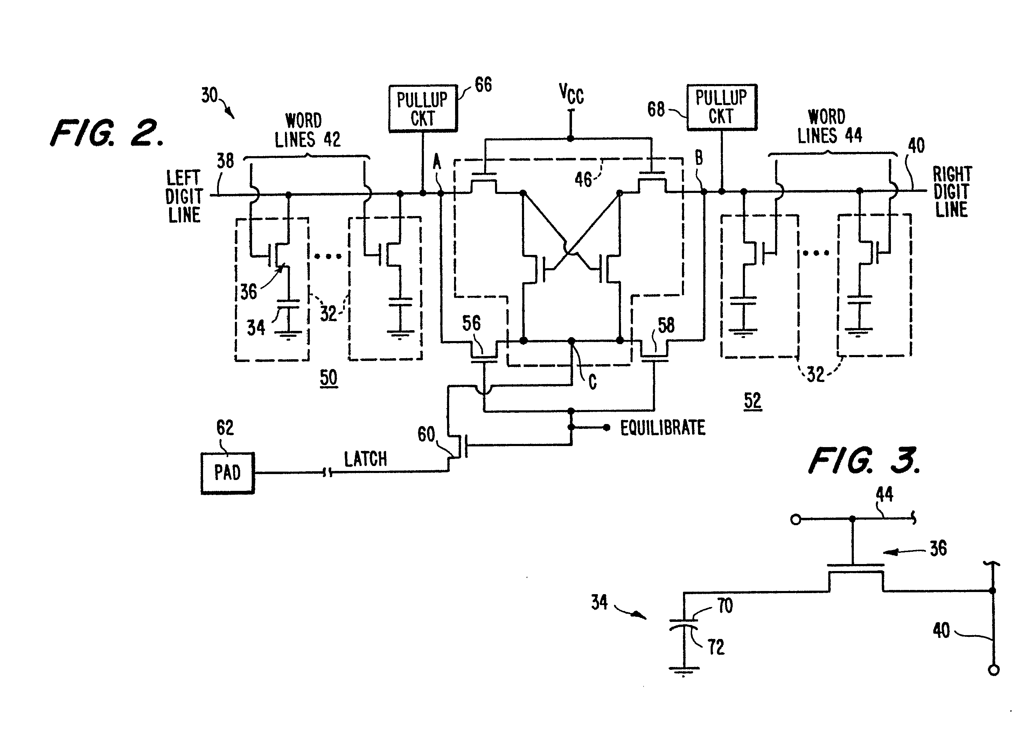

Figure 2 shows a schematic diagram of a portion of a typical DRAM used in detector 14. The circuit 30 comprises a plurality of cells 32, each of which contains a memory capacitor 34 and an access transistor 36. The individual cells are accessed through left and right digit lines 38 and 40, respectively, as well as word lines 42 and 44. A sense amplifier 46 is provided in the form of a cross coupled MOSFET detector circuit. The sense amplifier 46 has nodes A and B which are coupled to the left digit line 38 and to the right digit line 40, respectively. The cells 32 are divided into a left array 50 and a right array 52. The left array 50 is accessed by the left digit line 38 and the right array 52 is accessed by the right digit line 40. The word lines 42 access the individual cells of array 50 and the word lines 44 access cells of the array 52.

A pair of equilibrate transistors 56 and 58 couple the digit lines together to allow equalization of the digit lines at the end of a refresh cycle and during the precharge state of the next cycle.

The common drains of the cross coupled sense amplifier transistors at node C are connected through an isolation transistor 60 to a pad 62 on the periphery of the integrated circuit chip. The pad 62 is bonded to one of the leads of the circuit chip package.

A pair of pull up circuits 66, 68 are coupled, respectively, to the nodes A and B. The pull up circuits 66, 68 are voltage divider circuits operable to control the voltage level of the digit lines 38 and 40.

Figure 3 shows one cell of the circuit 30. For convenience, the cell is shown to be one of the array 52 but it could be any of the cells. As shown, the capacitor 34 has two plates 70 and 72 between which a charge is stored. Initially, the capacitor is charged by applying a high potential on word line 44 and a high potential on right digit line 40. This corresponds to a "1" state of the cell. In the presence of incident x-radiation, the charge on capacitor 34 is dissipated as will be discussed below.

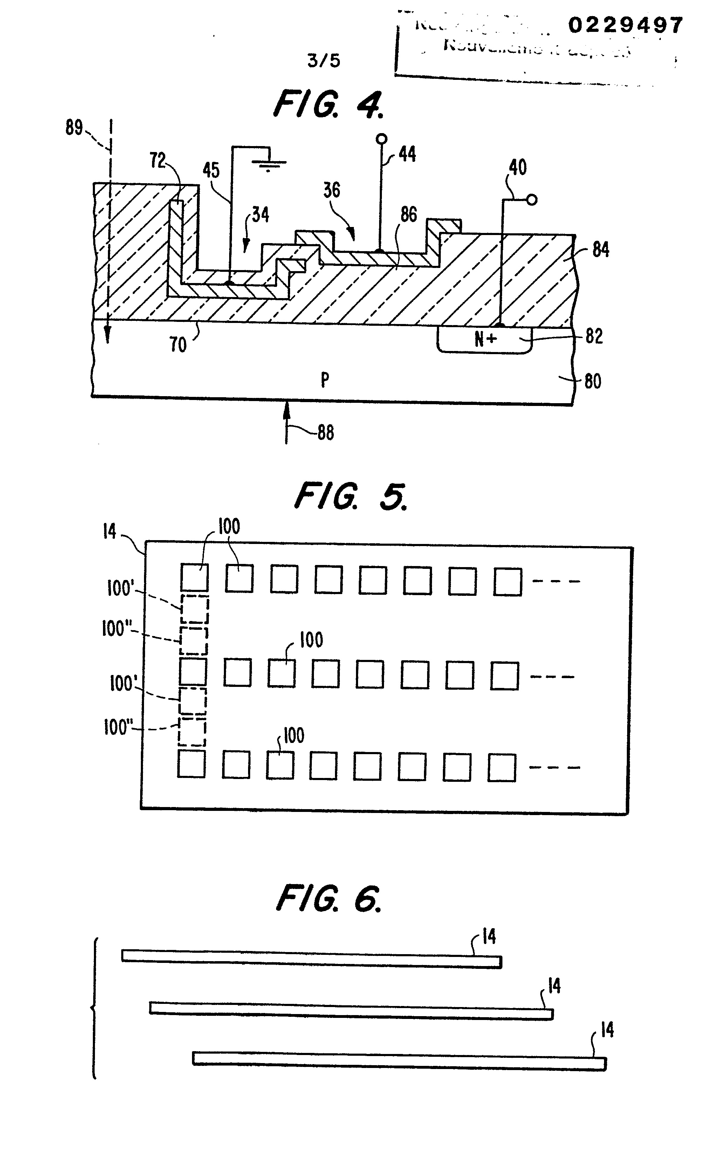

With reference to Figure 4, the portion of the integrated circuit containing the cell shown in Figure 3 is set forth in cross section. The circuit comprises a p-type silicon substrate 80 onto which an n+ region 82 has been added. A silicon dioxide layer 84 is deposited over the substrate and n+ region 82 to form an insulating layer. The lead 40 is connected to the n+ region to form the drain of transistor 34. A metal plate 86 is formed on the oxide layer 84 to form an insulated gate of transistor 36. The capacitor 34 is formed by a metal plate 72 and the interface 70 between p-type substrate 80 and oxide layer 84, which interface forms the other capacitor plate.

When the cell of Figures 3 and 4 is set to the "1" state, charge is built up on the interface 70 to charge the capacitor 34. The gate voltage is then lowered so as to discontinue communication between the drain voltage at line 40 and the capacitor 34. This charge is dissipated due to the absorption of x-ray photons in the substrate 80. In Figure 4, the direction of incident x-radiation is shown by the arrow 88. The x-radiation produces free electrons in the substrate 80 either by photoelectric effect, Compton scattering, or pair production. The number of electrons produced through pair production is negligible. Compton scattering and photoelectric effect have the highest probabilities of producing free electrons.

It is noted that interconnections between components of a cell and between cells are provided on the oxide layer of the semi-conductor. This is indicated in Figure 4 by showing the leads 40, 44 and 45 extending out of the oxide layer. Such leads represent the interconnections produced by the metalization layer of an integrated circuit.

Irradiation of the cell 30 from either side results in virtually all of the x-radiation being received in the substrate 80 so that the total electron production for any given energy level of radiation is achieved. The free electrons produced by interaction between the substrate and the x-radiation decrease the charge at junction 70 and thus decrease the charge on capacitor 34.

Compton scattering and the photoelectric effect are the relevant interactions causing the appearance of free electrons. The relative occurrences of the different reactions depends on the energy of the x-ray. There is little direction sensitivity except in the

case of Compton scattering, which is predominantly forward but also yields the least free electrons.

Referring again to Figure 2, it will be understood that the circuit 30 is of the type which employs a dynamic/active/restore sense amplifier of the type described in U.S. Patent Nos. 4,397,002 and 4,291,392.

In operation of circuit 30, during one cycle, a given word line 42, 44 in Figure 2 is brought to a logic one level to enable the addressed access transistor 36. The respective cell capacitor 34 is discharged into the appropriate digit line (e.g. digit line 40 for a capacitor of array 32) changing its voltage above the equalized value. Then, a latch signal from the pad 62 becomes a logic low state to enable operation of the cross coupled transistors and the sense amplifier 46 during absence of the equilibrate signal. The sense amplifier 46 responds to the latch signal by reducing the opposite digit line (in this case digit line 38) to a ground potential. The digit lines are connected by input/output circuitry (not shown), which provides a digital signal representing the content of the selected memory capacitor 36. The pull up circuits cause the right digit line to be pulled up to the level of the supply voltage. At approximately this time, the storage capacitor 34 which has been connected to the digit line has been restored to its original logic one state. The word line is then returned to ground to isolate the charge on the respective memory cell. The digit lines are then permitted to go low and the equilibration signal becomes a logic high to render the equilibrate transistors 56, 58 conductive to allow the digit lines to be connected for equalization. This permits the charge on the digit lines 38, 40 to be shared such that the digit lines equilibrate to a voltage approximately half way between the supply voltage and ground. A new cycle is thereupon ready to commence.

The latch signal is placed on pad 62 such that during the equilibrate signal, a voltage potential may be applied to the digit lines when they are connected to effect equilibrium. As will become apparent, the voltage which is applied to the pad 62 allows adjustment to the sensitivity of the image sensor. In particular, the digit line potential acts as a threshold to determine if a particular memory cell 36 is at a high or low voltage level. By raising the potential, cells may leak less before they are considered to be decayed from a logic one to a logic zero value. Accordingly, the sensitivity of the cells can be adjusted by adjusting this potential.

Another way of adjusting the sensitivity of the cells is by etching in different thicknesses of oxide material in the capacitor 34 shown in Figure 4. In other words, the thickness of the oxide between interface 70 and metal plate 72 determines the sensitivity of the capacitor to x-radiation. The thicker this layer, the more sensitive the capacitor is to radiation discharge. Accordingly, to make a more sensitive detector, the layer should be made thicker and to make a less sensitive detector, the layer should be made thinner. There are, however, limitations to this technique because the impedance of the capacitor must lie in a certain range in order for the circuit to function properly (varying the thickness changes the impedance).

A further technique for adjusting sensitivity is to adjust the exposure time of the detector cells. Using conventional x-ray source controlling equipment, the response of the cells can be adjusted either by using higher energy x-rays or by increasing the intensity of the x-rays. Clearly, in either case, the cells will react more quickly.

The cells of the detector are binary in nature. In many applications, it is useful to have a gray scale. This can be accomplished using any of the three techniques discussed above for varying the sensitivity of the cells.

If the digit line potential threshold is varied to vary the sensitivity, a plurality of cells may be grouped to form a pixel. For example, 8 cells per pixel could provide a gray scale having 7 levels, although in practice, 80 cells per pixel (79 gray scales) may be used to provide redundancy at each level of the gray scale. In Figure 2, if it is assumed that array 32 has 8 cells, ideally, this array could act as a single pixel. During the cyclic operation of the circuit 30, as discussed above, a different digit line potential is applied to digit line 40 when reading each of the memory capacitors 34 of array 32. In this manner, the soak time required for each of the cells 32 to discharge to a low level would be different, thereby providing a gray scale.

The preprocessing circuit 16 of Figure 1 is programmed to provide the necessary variations in threshold potential, as would be apparent to one of ordinary skill in the art.

Likewise, if each of the cells of array 32 forms a single pixel, each memory capacitor 34 could be produced with a different thickness of oxide layer. In this manner, the capacitors would have inherent differing sensitivities, thus producing a gray scale. Clearly, the number of cells in a pixel can be varied to produce a gray scale having as many levels as desired.

A third means of providing gray scale is to take several x-ray pictures with different soak times and to add the results. For example, with an object having a varying thickness, a plurality of images can be obtained using differing soak times. The lower soak times are used to depict the thinner portions of the object. By adding all of the images together, a multilevel gray scale image is obtained depicting the various thicknesses of the object.

The detector 14 can be produced in any desirable size. Conventionally, the largest silicon chips produced are 6" diameter circular wafers. The wafers are cut into individual integrated circuits and packaged as, for example, dual in-line packs. The detector 14 can be processed by conventional integrated circuit processing techniques and can be packaged in any conventional configuration such as the dual in-line pack.

Figure 5 shows a portion of a detector 14 having cells 100. The cells are each approximately 8 microns square and the cells of any row are spaced 9 microns from center to center. Thus, these cells are separated by only one micron. Vertically, as shown in Figure 5, the cells are spaced 25 microns from center to center. Also, the cells are arranged in banks of 32,000 with approximately 1/4 mm dead space between the banks. The dead space between cell banks is required to accommodate the trunk lines to the cells. The arrangement of cells in one integrated circuit is sufficiently dense to provide a very high resolution x-ray image for most applications. However, if an even higher resolution is required, since each chip is relatively transparent to radiation, a plurality of chips can be stacked and offset relative to one another to fill the gaps between cells and/or between the banks of cells. For example, as shown in Figures 5 and 6, three detectors 14 are stacked and offset so that the cells of the lower two detectors are positioned between the cells of the upper detector. In Figure 5, the cells of the lower detectors are indicated in phantom as cells 100' and 100''. Accordingly, it can be seen that a single detector can be built using three integrated circuits in which virtually all of the available area is filled with cells.

As an alternative to stacking detectors, several sequential images can be taken with either the source 12 (Figure 1) or the detector 14 being moved between each x-ray exposure. This motion is produced by oscillating supports 102 or 104 shown in Figure 1.

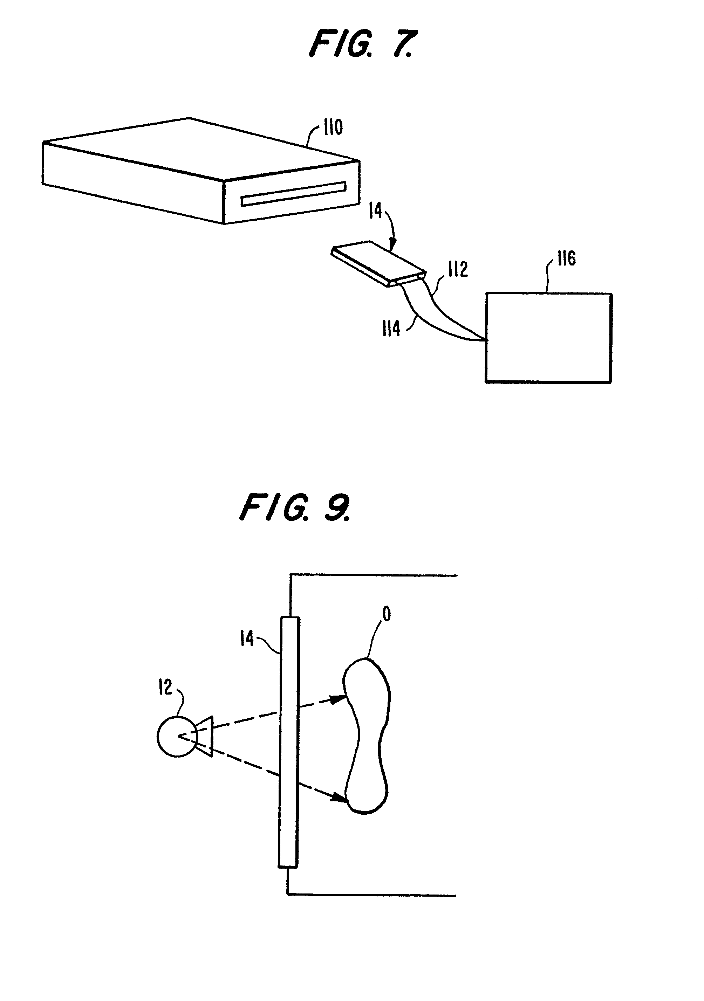

The integrated circuit itself is about 1/2 mm thick. The entire detector can be made about 13 mm thick, including all necessary connections etc. Accordingly, a detector 14 can be substituted directly for x-ray film in almost all existing x-ray devices. As shown in Figure 7, the detector 14 can fit directly into an x-ray film receptacle or support housing 110 with leads 112 and 114 being connected to the processing section 116 which contains preprocessor 16, image processor 18, etc. Processing section 116 may be a computer with the preprocessor and image processor being software components.

Another advantage of the fact that the detector 14 can be produced in small sizes is that relatively small detectors can be permanently located in virtually inaccessible areas of structures to be x-rayed. For example, structural elements in aircraft are required to be examined periodically using x-ray techniques. This normally requires disassembly of major structural components. However, with the present invention, an x-ray detector can be permanently mounted in place and the detector leads can be made accessible through a plug or the like. In this manner, x-ray analysis of structural components can be carried out quickly and easily. Also, since the detector 14 is made using conventional integrated circuit techniques, its cost is relatively low thus also contributing to the feasability of utilizing a plurality of small x-ray detectors 14 on a component requiring x-ray analysis.

Furthermore, the small size of the x-ray detector 14 enables it to be placed in body cavities such as the ear or the like to facilitate clear clinical diagnostic x-ray images.

The fact that each cell of detector 14 is small in size enables the use of an x-ray source 12 having the smallest focal spot available. Also, since the cells are relatively closely packed, the present invention can be used in zoom radiography without requiring any change in the distance between the source and the detector. Normally, the size of an x-ray image can be increased by increasing the distance between the object and the detector. However, in the present invention, due to the large number of cells in the detector, the image can be electronically enlarged without significant loss of resolution by merely displaying the image on a larger fraction of the screen. Further, as discussed above, if additional resolution is required, detectors 14 can be stacked as shown in Figures 5 and 6.

Due to the small size of the cells of the invention, greater resolution can be achieved with little or no cross talk between the cells. That is, the length of travel of the most energetic secondary radiation produced by interactions between the x-ray beam and the silicon substrate 80 (Figure 4) is approximately 10 microns. Since this is also approximately the spacing of the cells, there is very little probability that radiation impinging upon one cell will result in noise being produced in an adjacent cell.

Furthermore, the present invention is suited for microradiography since the cells are small and closely packed. The resolution attainable using the invention is sufficiently high to permit an accurate representation of objects having an area on the order of 1,000 square microns.

Also, because of the digital nature of the present invention and its inherent compactness, it is possible to configure an x-ray imaging system in a unique way that permits the user to view the internal structure of objects where it is not possible or practical to place the imaging media behind the object. As shown in Figure 9, the x-ray source 12 is placed directly behind the detector 14 which can be placed directly on or in front of the object 0 to be viewed. In this configuration, the x-ray field produced by the source penetrates through the detector and impinges on the object. The image of the object is created in the detector by back scattered radiation from the object. The image produced in the detector 14 is that of the object 0 produced by back scattering superimposed on an image of the source 12 produced by the x-ray field passing through the detector 12 initially. The image of the source 12 can be removed by subtracting it from the total image. That is, an image of the source alone is produced by irradiation of the detector 14 with no object present and this image is digitally subtracted from that of the combined object and source image.

It should be noted that it is preferable to orient detector 14 in Figure 9 such that the connection leads extend out of the side facing the source. In this way, the detector can be positioned closer to the object 0 and the image of the leads, etc. will be present when the image of the source alone is produced and thus will not appear in the final image after digital subtraction.

Furthermore, by varying the energy of the x-ray field with multiple exposures, back scatter tomography is made possible, wherein a 3-D image of the object can be constructed.

The measured inherent sensitivity of cells of a detector vary by about 20%. Furthermore, it has been discovered that the sensitivity of the detector 14 is varied by prolonged exposure to x-radiation. That is, as cells of the detector are exposed, they become more sensitized to radiation in the future. Thus, detectors which receive less radiation dose because they are shadow shielded by an object are less sensitized than those exposed to direct or less attenuated radiation. Therefore, the relative sensitivity of each detector varies according to its own history of exposures. X-ray applications with typically useful image gray scales do not allow such large sensitivity variations and thus require sensitivity normalization. Such normalization can be carried out using the following technique. For the following discussion it is assumed that the detector comprises one half of a basic IS32 detector configuration, i.e. a 128 x 256 cell array contained in a spatial area 876.8 x 4420 microns. The cells are arranged in 128 rows and 256 columns. Presuming that the cells are illuminated by a source which generates a uniform intensity field at the sensor, a distribution of "exposure times", $t$, will be obtained to register a cell discharge. The individual cells are denoted by $t(m,n)$ where $m$ is $1,2,3,\ldots,M$ and $n$ is $1,2,3,\ldots,N$. The letter $m$ signifies the row index and the letter $n$ signifies the column index. In the present example, $M$ is 128 and $N$ is 256. Denoting the average value of this array of 32,768 values by $t^*$, note that the 20% variability discussed above means that the difference of $t(m,n)$ and $t^*$ can be as large as $0.2t^*$. The cell array normalization factors can be defined by $f(m,n)$ which equals the ratio of $t^*$ to $t(m,n)$. Thus we can generate the array $f(m,n)$ where m is 1,2,...,M and n is 1,2,...,N. In measuring the set of values $t(m,n)$ we must set a time increment used to step through the cells. Certainly this increment should be less than $0.2t^*$ or the measurement will be of little value.

Where gray scale is produced by sequential exposures of the object with different exposure times, the gray scale will be specified by a set of contiguous exposure time intervals. Denote the increasing bounds of these intervals by $t(j)$ where j is 0,1,2,...,J. This defines a J-gray scale image mode (typically J is 8, 16, 32 or 64) bounded by a low exposure time of $t(0)$ and a high exposure time of $t(J)$. The j-th shade of gray is bounded by exposure times of $t(j-1)$ and $t(j)$. The image intensity measured by the radiation field at sensor locations varies inversely with j.

In a particular image obtained with the J-gray scale just described, an array of values $t(m,n)$ will be obtained where m is 1,2,...,M* and n is 1,2,...,N*. It may not be necessary to use information from all of the cells, or the cells may be divided into groups and spatially averaged in each group. The values of M* and N* are respectively equal to or less than M and N depending on either the fraction of cells used, or cell spatial averaging procedures. This array of cell exposure times contains the image information. Since image exposure times are only at the specified values $t(0)$, $t(1)$,...,$t(J)$ the image values of $t(m,n)$ will fall in one of the discrete J gray scale intervals and no further detailed knowledge can be presumed. Each cell response to the image must be corrected by the sensitivity normalization $f(m,n)$. There are a variety of ways that this correction can be applied.

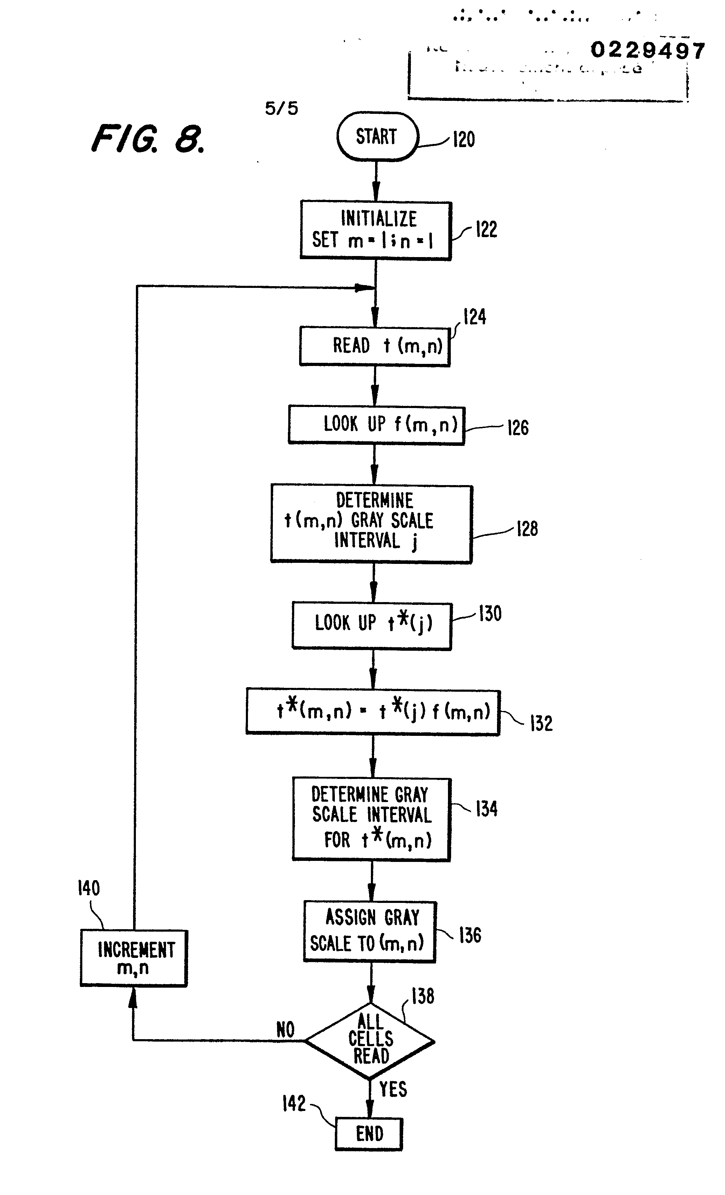

One method of carrying out this correction is shown by the program of Figure 8. This program is run to read each cell at each exposure. In other words, the first exposure time t(0) may be 1.1 sec, the second exposure time t(1) may be 1.2 sec, etc. After each exposure, all of the cells t(m,n) are read and the information output from each cell is stored in a matrix.

In Figure 8, the program is started at step 120 and the variables are initialized at step 122. This includes setting m and n equal to one. At step 124, the value of the first cell t(m,n) is read and the normalization factor for that cell is looked up at step 126. At step 128, the gray scale interval j is determined. For example, if the cells are being read after the first exposure and the exposure time is 1.1 sec, the gray scale interval j would be 1.1-1.2 sec. If the second exposure time is 1.2 sec, the second gray scale interval would be 1.1-1.2 sec, etc.

At step 130, an exposure time t*(j) characteristic of the j-th interval for each j is identified. For example, t*(j) could be the simple average; one-half of the sum of t(j) and t(j-1). In other words, if the interval 1.1-1.2 sec is the current interval j, it is necessary to assign a single value t*(j) to the exposure time. This value may be, e.g., 1.15 sec. Then, at step 132, for each image spatial location (m,n) which has an image value t(m,n) in gray scale interval j, calculate f(m,n)t*(j) which yields the corrected value t*(m,n). This value: 1) falls in interval j and then the assignment of gray shade j for (m,n) is maintained; 2) falls in some other interval j' and then the assignment of corrected gray shade j' for (m,n) is accomplished; 3) is less than t(0) and then (m,n) is assigned "white"; or 4) is greater than t(J) and then (m,n) is assigned "black". The determination of the gray scale interval for t*(m,n) is made at step 134 and the actual assignment of the gray scale is made at step 136. Clearly the choice of t*(j) and the validity of the procedure is less uncertain when the intervals t(j-1) to t(j) are "small". Small is relative to expected cell sensitivity variation over the image in question. At step 138, a determination is made as to whether all cells have been read. If the answer is "no" the values of m and n are incremented at step 140 according to a predetermined schedule and the value of the next cell is read. After all the cells are read, the program ends at step 142.

The foregoing description is provided for purposes of illustrating the present invention but is not deemed to be limitative thereof. Clearly, numerous additions, substitutions and other changes can be made to the invention without departing from the scope thereof as set forth in the appended claims.

Claims

1. An x-ray imaging system comprising:
an x-ray source for producing an x-ray field;
an x-ray detector comprising a solid state integrated circuit having a semiconductor substrate and having a plurality of charge storage devices, and circuit means for placing a charge on said charge storage devices, said charge storage devices being disposed in an x-ray permeable material, and said detector being positioned in said x-ray field such that said charge is dissipated by secondary electronic effects produced by interaction between said x-ray field and said semiconductor substrate of said solid state integrated circuit.

2. An x-ray imaging system as claimed in claim 1 wherein said detector is placed between said source and an object to be viewed such that said x-ray field passes through said detector, impinges on said object and forms an image of said object in said detector by back scatter from said object.

3. An x-ray system as claimed in claim 2 including means for subtracting an image of said source from the image produced in said detector.

4. An x-ray imaging system as claimed in claim 1, 2 or 3 wherein said charge storage devices are divided into groups to form pixels, each pixel having a plurality of charge storage devices and means for varying the sensitivity of said charge storage devices in a single pixel to provide a gray scale.

5. An x-ray imaging system as claimed in claim 4 wherein said varying means comprises different thickness oxide layers in said charge storage devices.

6. An x-ray imaging system as claimed in claim 4 wherein said varying means comprises means for providing different comparison voltage levels for determining the charge on said charge storage devices.

7. An x-ray imaging system as claimed in any of claims 1 to 3 wherein each said charge storage device forms a single pixel of an image formed on said detector.

8. An x-ray imaging system as claimed in any preceding claim including a support housing for said detector, said support housing having means for removably receiving said detector.

9. An x-ray imaging system as claimed in claim 8 wherein said detector has a thickness on the order of 1/2 mm.

10. An x-ray imaging system as claimed in any preceding claim wherein each of said charge storage devices is contained within a cell having a greatest dimension of no more than 10 microns.

11. An x-ray imaging system as claimed in any preceding claim wherein said integrated circuit comprises a dynamic random access memory.

12. An x-ray imaging system as claimed in any preceding claim wherein said circuit means comprises transistors for connecting said charge storage devices to a voltage source.

13. An x-ray imaging system as claimed in any preceding claim including means for moving one of said x-ray source and said detector relative to the other by a distance approximating the distance between charge storage devices in said detector.

14. An x-ray imaging system as claimed in any of claims 1 to 12 including a plurality of x-ray detectors positioned over one another such that the cells of each x-ray detector are staggered with the cells of the other x-ray detectors such that any one cell of any one x-ray detector is positioned between two cells of another x-ray detector.

15. An x-ray imaging system as claimed in any preceding claim including means for normalizing the soak times required for discharging all of the charge storage devices which are intended to discharge simultaneously.

16. An x-ray imaging system as claimed in claim 15 wherein said normalization means comprises means for storing a different normalizing factor for each of said cells.

17. An x-ray imaging system as claimed in any preceding claim including means for exposing the detector to said source for sequential, varying lengths of time to produce a plurality of images, and adding said images together to provide a gray scale.

18. An x-ray imaging system as claimed in claim 17 wherein the ranges between said sequential varying length exposure times are assigned different gray scale values.

19. A method of detecting an x-ray image comprising:

storing charges on a plurality of charge storage devices formed in an integrated circuit material, said charge storage devices being formed by a junction between a semiconductor substrate and an oxide layer, and a metal surface formed on said oxide layer;

exposing said integrated circuit to an x-ray field such that said x-ray field interacts with said substrate to produce secondary electronic effects to reduce the charge on said charge storage devices.

20. A method according to claim 19 including producing an image having a gray scale by sequentially exposing said integrated circuit with different exposure times and digitally adding the images obtained at each of said exposure times.

21. A method according to claim 19 or 20 comprising producing a back scattered image by positioning said integrated circuit between said source and an object to be viewed, causing said x-ray field to pass through said integrated circuit and form an image in said integrated circuit through back scattering from said object.

22. A method according to claim 19 including normalizing the outputs from said charge storage devices to compensate for different sensitivities said charge storage devices.

FIG. 1.

10

HIGH RESOLUTION MONITOR (IMAGE DISPLAY) 20

22

LASER DISC RECORDER (ARCHIVING)

12

0

DETECTOR

14

16

18

COMPUTER MONITOR 26

IMAGE PROCESSOR

KEYBOARD

28

24

DRY SILVER PRINTER (HARDCOPY OUTPUT)

102

104

PRE-PROCESSOR (NORMALIZATION)

FIG. 2.

30
WORD LINES 42
PULLUP CKT
66
VCC
68
PULLUP CKT
WORD LINES 44
40
38
LEFT DIGIT LINE
A
46
B
RIGHT DIGIT LINE
36
34
32
56
58
32
50
C
52
62
PAD
LATCH
60
EQUILIBRATE
44
36
34
70
72
40

FIG. 3.

FIG. 4.

89 72 45 34 36 44 86 40 84 70 N+ 82 P 80 88

FIG. 5.

14 100 100' 100" 100 100' 100" 100

FIG. 6.

14 14 14

FIG. 7.

110
14
112
116
114

FIG. 9.

0
14
12

*FIG. 8.*

START
120
INITIALIZE
SET m = 1; n = 1
122
READ t (m,n)
124
LOOK UP f(m,n)
126
DETERMINE
t (m,n) GRAY SCALE
INTERVAL j
128
LOOK UP t*(j)
130
t*(m,n) = t*(j) f (m,n)
132
DETERMINE GRAY
SCALE INTERVAL
FOR t*(m,n)
134
ASSIGN GRAY
SCALE TO (m,n)
136
ALL
CELLS
READ
138
NO
YES
INCREMENT
m,n
140
END
142

European Patent Office

# EUROPEAN SEARCH REPORT

0229497

Application number

EP 86 30 9675

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,Y | US-A-4 245 158 (BURSTEIN & KRIEGER) * Abstract; column 2, lines 28-61; column 3, line 50 - column 4, line 12; figures * | 1,7,19 | G 01 T 1/29 |
| A | | 9,11, 17,20 | |
| | --- | | |
| A | NUCLEAR INSTRUMENTS & METHODS ON PHYSICS RESEARCH, section A, vol. 226, no. 1, September 1984, pages 26-33, Elsevier Science Publishers B.V., Amsterdam, NL; C. DAMERELL: "Applications of silicon detectors in high energy physics and astrophysics" * Page 27, section 1.4: "CCD detectors"; page 30, section 2.2: "X-ray detectors" * | 1,7,10 ,19 | |
| | --- | | TECHNICAL FIELDS SEARCHED (Int Cl 4) |
| Y | EP-A-0 086 928 (NASA) * Abstract; page 2, lines 12-31; page 3, line 37 - page 4, line 1; page 6, line 15 - page 7, line 7; figures * | 1,7,19 | G 01 T<br>H 01 L |
| A | | 4,20 | |
| | --- -/- | | |

The present search report has been drawn up for all claims

| Place of search | Date of completion of the search | Examiner |
|---|---|---|
| THE HAGUE | 18-03-1987 | DATTA S. |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent Office

# EUROPEAN SEARCH REPORT

Application number

EP 86 30 9675



## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 413 280 (ADLERSTEIN et al.) * Abstract; column 3, lines 5-59; column 4, lines 13-30; figures * | 1,7,14,19 | |
| A | NUCLEAR INSTRUMENTS & METHODS, vol. 169, no. 1, February 1980, pages 125-128, North-Holland Publishing Co., Amsterdam, NL; G. CEROFOLINI et al.: "A proposal: dynamic RAMs as particle detectors" * Page 125, "Introduction"; figure 1 * | 1,4-7,11 | |

TECHNICAL FIELDS SEARCHED (Int. Cl.4)

The present search report has been drawn up for all claims

| Place of search | Date of completion of the search | Examiner |
|---|---|---|
| THE HAGUE | 18-03-1987 | DATTA S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document